(19) Europäisches Patentamt

European Patent Office

Office européen des brevets

(11) **EP 1 565 787 B1**

## (12) EUROPEAN PATENT SPECIFICATION

(45) Date of publication and mention
of the grant of the patent:
**11.02.2009 Bulletin 2009/07**

(21) Application number: **03775543.6**

(22) Date of filing: **12.11.2003**

(51) Int Cl.:
**G03F 7/00** (2006.01)

(86) International application number:
**PCT/GB2003/004911**

(87) International publication number:
**WO 2004/051371 (17.06.2004 Gazette 2004/25)**

(54) **Stamp, method of its fabrication and use of it**

Stempel, Methode zu seiner Herstellung und Gebrauch desselben

Gabarit, méthode de sa fabrication et son usage

(84) Designated Contracting States:
**AT BE BG CH CY CZ DE DK EE ES FI FR GB GR
HU IE IT LI LU MC NL PT RO SE SI SK TR**

(30) Priority: **29.11.2002 GB 0227902**

(43) Date of publication of application:
**24.08.2005 Bulletin 2005/34**

(73) Proprietors:
• **Ingenia Holdings Limited
Road Town, Tortola (VG)**
• **INGENIA TECHNOLOGY LIMITED
London EC1N 8JA (GB)**

(72) Inventor: **SHUNPU, Li
Cambridge CB5 8QH (GB)**

(74) Representative: **Meldrum, David James
D Young & Co
120 Holborn
London EC1N 2DY (GB)**

(56) References cited:
**WO-A-01/33300**          **DE-A- 10 030 016**
**US-A- 5 948 470**          **US-A1- 2002 005 391**
**US-A1- 2002 042 027**

• **SUH K Y ET AL: "CAPILLARY FORCE
LITHOGRAPHY: LARGE-AREA PATTERNING
SELF-ORGANIZATION AND ANISOTROPIC
DEWETTING" ADVANCED FUNCTIONAL
MATERIALS, WILEY INTERSCIENCES,
WIENHEIM, DE, vol. 12, no. 6/7, June 2002
(2002-06), pages 405-413, XP001123877 ISSN:
1616-301X**

**Description**

The present invention relates to a template for use in the manufacture of structures on the nanometre scale.

The provision of templates for use in the production of structures on the nanometre scale and, in particular, the provision of templates to produce very detailed and intricately patterned structures is very difficult.

"Capillary Force Lithography: Large-Area Patterning, Self-Organization, and Anisotropic Dewetting Kaph et al., Advanced Functional Materials, vol. 12, No 6-7, or metal layer June 2002, discloses a lithographic technique called capillary force lithography.

According to the present invention, there is provided a template formed from a layered structure comprising a substrate and the a single-phase polymer layer positioned on the substrate and a semiconductor layer on the polymer layer wherein the polymer layer comprises a textured surface, the texturing being caused by induction of stress in the polymer layer in presence of the semiconductor layer.

According to the present invention, a method of manufacture of a structure on the nanometre scale comprises the steps of providing a template as defined above, molding a material on to the template and removing the molded material from the template to provide the desired structure.

According to the present invention, there is provided a template according to claim 1.

The present invention therefore surprisingly utilises the fine structures generated by topographic instabilities in single-phase polymer films, and thus enables the production of highly intricate, organised structures on the nanometre scale, so-called "nanostructures".

The method of making a template according to the present invention provides a simple, fast and effective way of producing a template, which may then be used in the production of nanostructures for use in a variety of applications. Patterning of the template may be controlled by optimisation of the fabrication parameters, for example the temperature or polymer film thickness employed.

The template of the invention may be used in the manufacture of a variety of nanostructures such as arrays, grids and electronic or optical devices such as polarisers. Such structures have many applications not only in the fields of optics and electronics but also, for instance, in molecular separation techniques, for example the separation of DNA. Also, unlike processes which involve the use of patterned substrates, the method of manufacture of the invention does not employ lithography and therefore provides a new avenue for the fabrication of nanostructures.

The substrate comprised in the template of the invention is preferably inorganic and more preferably comprises silicon. The thickness of the substrate will typically be approximately 0.5 mm.

Any single-phase polymer may be comprised in the template of invention, however, the single-phase polymer is preferably selected from polymethylglutarimide (PMGI), polymethylmethacrylate (PMMA) and photoresists, such as AZ5214E, which is manufactured by Clarilant GmbH and comprise 2-methoxy-1-methylethylacetate as its main component. More preferably, the single-phase polymer is PMGI. The thickness of the single-phase polymer layer may vary depending on the intricacy of the desired texturing or patterning of the template, however, it is typically in the range 50-300 nm.

The template additionally comprises a thin, rigid layer of a semiconductor or a metal layer. This layer is positioned on the single-phase polymer layer and will typically have a thickness of approximately 10 nm.

The semiconductor will preferably be germanium, which is favourable for further pattern transformation.

In the method of making a template according to the invention, the layer of single-phase polymer may be deposited on to the substrate by any conventional method such as coating, painting or spraying for example. The resulting structure is then baked at a temperature below the glass transition temperature ($T_g$) of the single-phase polymer such that a degree of instability remains in the polymer to form a firm but flexible film on top of the substrate. If a baking temperature of higher than the $T_g$ of the polymer is employed, no instability remains in the polymer. If the single-phase polymer is PMGI, which has a $T_g$ of approximately 200˚C, a temperature of less than 200˚C will therefore typically be employed. Preferably the temperature or this baking step is in the range 120-200˚C.

A semiconductor layer or metal layer is deposited on to the single-phase polymer layer. In this embodiment of the method according to the invention, the semiconductor layer may be deposited on to the polymer layer by any conventional method such as sputtering. The semiconductor layer is preferably applied to a structure comprising a substrate coated with a single-phase polymer layer which has preferably already been subjected to a baking step at a temperature of below the $T_g$ of the polymer. Following deposition of the semiconductor layer on to the polymer layer of such a structure, the resulting three-layer structure is then subjected to a further baking step again at a temperature of below the $T_g$ of the polymer layer

A surface of the polymer layer covered with the semiconductor layer is textured via induction of stress into the layered structure. The stress induced in the layered structure is typically in the range 0.5-1 MPa.

The nature of the texture or pattern so-produced .is highly dependent on the applied stress, which can be applied such that highly organised and complicated patterns are achieved. For example, if a tensile or compressive strength is applied, a lined pattern in the direction of the stress will be generated in the surface of the polymer layer.

Preferably, stress-induction in the polymer layer results in the formation of parallel grooves in the surface of the polymer layer. These parallel grooves are created because, under stress, the formation of waves with a vector in the stress direction becomes energetically unfavourable thus producing periodically bordered structures in the surface of the polymer layer. This idea is analogous to pulling a wrinkled table cloth in opposite directions. The polymer film-thus provides a uniform striped pattern with a characteristic wavelength ($\lambda$) as the instability in the polymer layer is controlled by spinodal dewetting, ie. the dewetted wave structure is characterised by a single wavelength.

One way in which stress may be induced in the polymer layer is via the use of a load bearing member comprising at least one contact surface which engages the surface to be textured. The load bearing member employed in this embodiment of the method of the invention may comprise polydimethylsiloxane (PDMS), and typically has the shape of a truncated prism. The contact surface of the load bearing member may be smooth or may itself be textured.

The template of the invention is employed in the manufacture of structures on the nanometre scale, which are typically made from materials such as metals, alloys, ceramics and polymers.

The structures so-produced may include arrays, grids, electronic devices and optical devices, such as polarisers. Of particular interest are magnetic wire arrays, such as those comprising Permalloy ($Ni_{80}Fe_{20}$) which may be used in device applications.

The present invention will now be described with reference to the following examples and to the accompanying drawings. In the drawings:

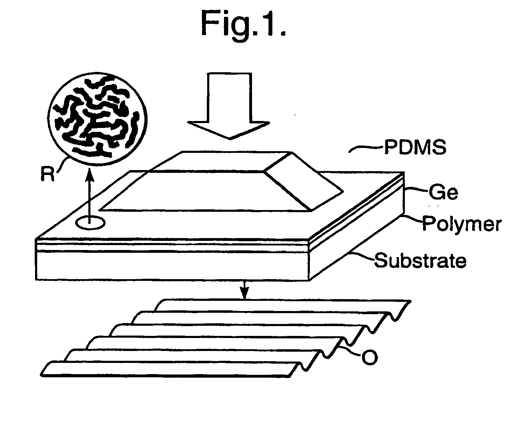

Figure 1 is a side perspective view illustrating the stress-induction step of the method of making a template according to the present invention, including an enlarged detail of a textured surface of the template of the invention;

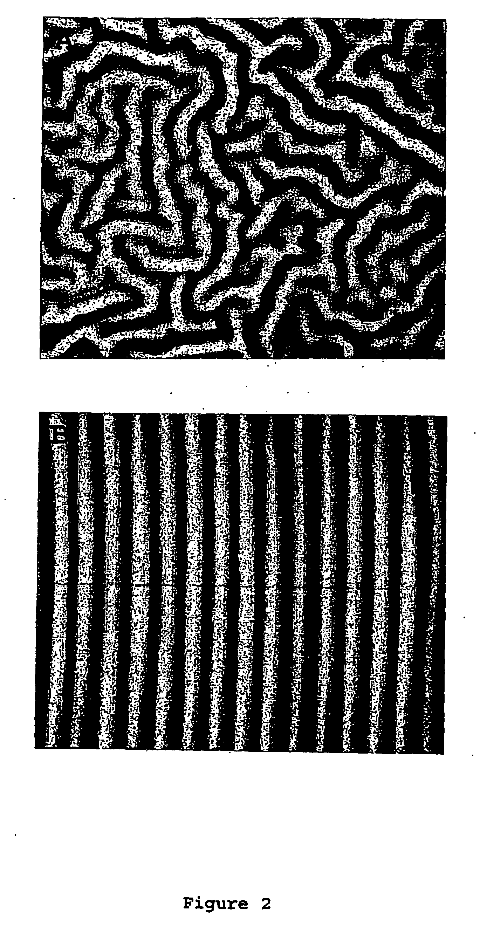

Figure 2 shows atomic force microscope (ASM) images of (A) a randomly textured surface taken from a 150 nm thickness PMGI film following baking at 160°C, and (B) an ordered surface resulting from stress-induction in a 250 nm thickness PMGI film following baking at 160°C;

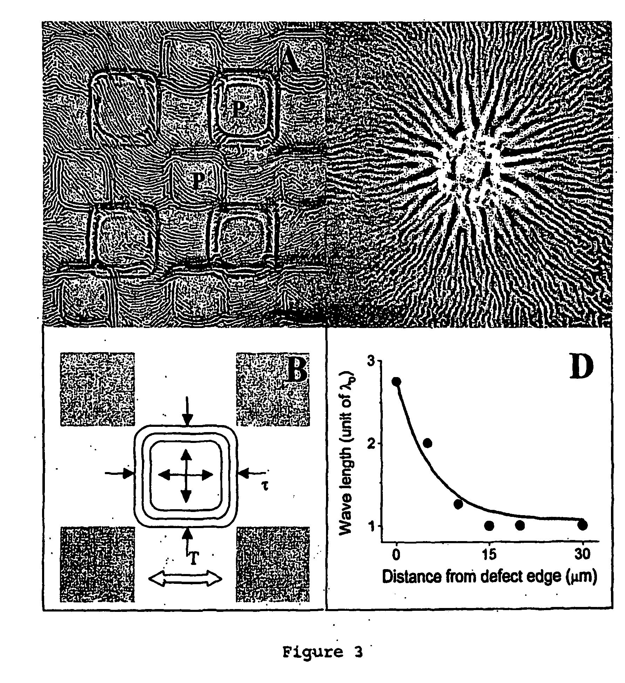

Figure 3 illustrates surface patterns induced by localised stress and the analysis thereof. (A) shows a surface structure obtained by pressing a sample surface using a PDMS load bearing member which is patterned with 20 $\mu$m square anti-dot patterns; (B) is a schematic illustration of the local stress distribution in sample A in which, for simplicity, only important stress components, $\tau$ are shown; (C) shows a defect-induced structure ordering; (D) illustrates the distance dependence of the wavelength in the vicinity of the defect;

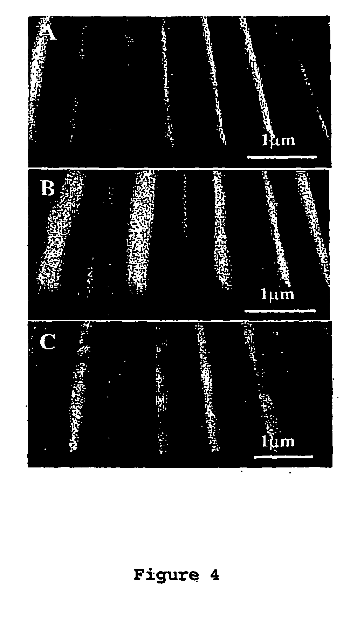

Figure 4 shows modulated wire patterns obtained by surface wave interference, as follows: (A) a uniform pattern ($\Phi_1$) aligned at 160°C; (B) a double-line pattern observed after heating sample with structure shown in (A) for 10 min at 205°C; and (C) a single/double-line modulated pattern obtained after heating the sample shown in (A) to 190°C for 10 min.

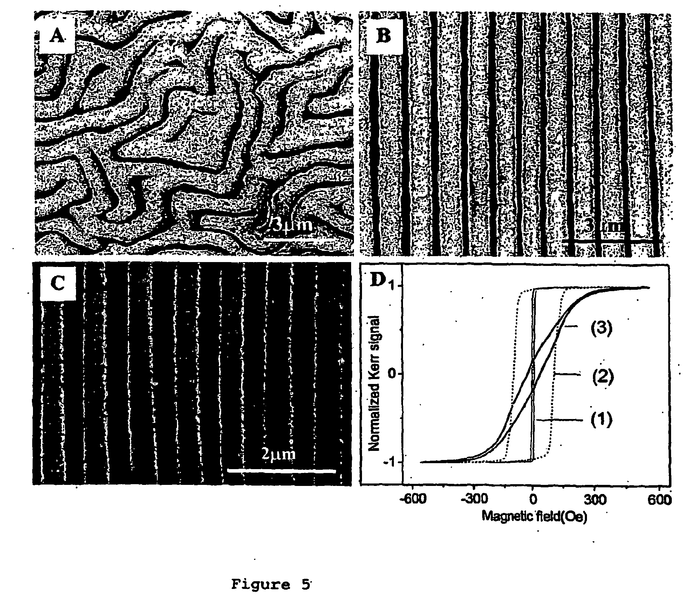

Figure 5 shows scanning electron miscroscopy (SEM) images of the fabricated structures and magnetization reversal measurement of the superalloy wires, as follows: (A) and (B) are two PMGI polymer structures (random and aligned, respectively) defined by sequential plasma etching, in which nanochannels were etched to the silicon substrate; (C) shows a Permalloy wire array obtained by lift-off; (D) illustrates magnetic hysterisis loops measured on 400 nm width and 30 nm thick Permalloy wire arrays, in which loop 1 was taken from an unpatterned film and loops 2 and 3 were taken when the magnetic field was applied along and perpendicular to the wire axis respectively.

Example 1: Formation of a template using a load member with a smooth contact surface.

250nm and 150nm thick layers of PMGI (Micro Chem Corp., PMGI SF6) were spin-coated separately on to silicon substrates and baked at 170°C for 30 min. Then 10nm-thick germanium was deposited on to the PMGI layers by sputtering. Random wave patterns were observed when heating the samples above 130°C, which is well below the $T_g$ of pure PMGI (approximately 200°C).

A PDMS elastic truncated prism with a smooth contact surface was pressed on to each sample surface as shown in Figure 1. This Figure shows that when pressure was applied to the PDMS prism, the intended lateral expansion of the PDMS prism generated a stress along the film plane and rendered the assembled surface structure ordered (panel O), while on the free sample surface random wave pattern were formed (panel R).

The atomic force microscope (AFM) images of the two sample surfaces after heating at 160°C for 25 min are shown in Figure 2. Figure 2A shows a 150 nm thickness film with a free surface, which comprises random waves, while in the case of an applied load to the 250 nm thickness film, the waves are well ordered as shown in Figure 2B. The area of the ordered structure can extend over the whole sample (centimetre scale) with millimetre size domains induced by non-uniform deformation of the PDMS prism.

In this example, the applied load was 0.5-1 MPa. A similar order of lateral expansion stress within the sample surface is expected because of the high Poisson's ratio of the PDMS. The mechanism of wave formation is based on the stress assisted dewetting of the polymer film involved, which is fundamentally different from those of other observe wave structures, such as mechanical compression induced surface buckles. After removal of the applied load the sample was annealed at 160˚C for ten hours and the ordered structure remained stable.

Example 2: Formation of a template using a load member with a Patterned contact surface.

A load member comprising a patterned contact surface was formed by casting PDMS against a 1.5 $\mu$m thick patterned photoresist layer. The resulting. PDMS structure was cut into a rectangular shape to provide a PDMS load member patterned with a 20 $\mu$m square anti-dot pattern.

This member was pressed into a germanium-capped PMGI film at 160˚C for 25 min. As the PMGI film was elastic, there were clear traces of the PDMS patterns printed on the sample surfaces, as indicated by the letter P in Figure 3A. In addition to these patterns, a new set of square patterns (as indicated by P') was formed, which appeared as a copy of the initial PDMS pattern.

This additional formed patterning may be explained as follows. When the PDMS was compressed on the sample surface, the regions between holes started to expand as shown in Fig. 3B. The five typical expanding parts (the centre and four arms of a cross as indicated) generated a compressive strain in a square-framed region thus aligning the patterns long the frame. The asymmetry of the alignment of ripples is attributed to the existence of an off-normal force applied to the PDMS, which generates a tension along the horizontal direction, as shown by the open arrow in Figure 3B.

In general, the value of applied stress is expected to be much smaller than the internal stress of a film, which is responsible for the film instability. The external stress is used merely to suppress the structural disorder induced by thermal fluctuation and to align the wavelike patterns. The internal stress, which causes film instability, is accumulated due to the temperature rise during annealing and can be expressed as:

$$\sigma_0 = \int_{T_0}^{T} \frac{E_c}{1-v_c}(\alpha_p - \alpha_c)dT \qquad (1)$$

where To and T are, respectively, the stress free temperature and the temperature to which the film is heated, $E_c$ is the Young's modulus and $V_c$ the Poission's ratio of the germanium film, and $\alpha_c$ ($\alpha_p$) is the thermal expansion coefficient of the polymer film. For a PMGI film without a germanium capping layer no instability is found and the substrate effect can therefore be neglected. It is difficult to calculate the value of $\sigma_o$ precisely since the value of $\alpha_p$ depends strongly on the temperature and an additional polymerized layer could form at the interface between the polymer and the capping (germanium) layers. However, a reasonable estimate gives $\sigma_o$ of approximately 100 MPa, based on $E_c / (1-v_c) \sim 10^{11}$ pa and $(\alpha_p - \alpha_c)$ $(T-T_o) \sim 10^{-3}$. This is about two orders higher than the applied stress. Thus, the applied stress only acts as a small perturbation to the isotropic internal stress $\sigma_0$ and introduces an anisotropy which leads the structure to order.

This can be further understood through the examination of the ordering of a local structure generated by a defect centre. Figure 3C shows a typical structure at the vicinity of a defect on a load free sample. When a defect, for example a dust particle or pin hole, exists in a polymer film restrained by a capping (germanium) layer, the break of film continuity leads to a redistribution of stress inside the film. By expressing the radial and traverse components of the stress around the defect as $\sigma_r$ and $\sigma_t$, respectively, this gives:

$$\sigma_r = \sigma_o \ (1-e^{-r/\xi}), \qquad (2a)$$

$$\sigma_t = \sigma_o \ (1-v_c e^{-r/\xi}), \qquad (2b)$$

where r is the radius calculated from the edge of the defect and $\xi$ is a characteristic length of the stress distribution. For stress-assisted instability in a rubber-like polymer film, the relationship between the surface wavelength and stress is $\lambda = k/\sigma^2$, where $K$ is a constant. Considering that the redistribution of material during formation of the wavelike structure is caused by the internal stress along the wave vector direction, it follows that:

$$\lambda = \frac{\lambda_o}{(1 - v_c e^{-r/\xi})^2} \qquad (3)$$

where $\lambda_0$ is the wave length of the structure far away from the defect centre. Taking $v_c=0.4$, the characteristic length $\xi$ was found to be about 10 $\mu$m by fitting equation (3) with experimental results as shown in Figure 3D. If the radius of the whole ordered region is taken to be 20$\mu$m (see Figure 3C), a value of the stress anisotropy required for ordering the structures in a sample from equation (2) may be obtained as follows:

$$a = \frac{\sigma_t - \sigma_r}{\sigma_t + \sigma_r} \sim 4\% \qquad (4)$$

This result confirms that a small perturbation in the stress can dramatically modify the structure morphology.

Example 3: Provision of complex patterning *via* changes in experimental_conditions.

This Example provides another method of making a template , the so-called "surface wave interference", to create more complex patterns. The wavelength of surface patterns is normally determined by the fastest growing wave mode in the system and strongly depends on experimental parameters. If a wave pattern $\Phi_1=\varepsilon_1(t)e^{tq_1x}$ is the characteristic mode in a given experimental condition, a rapid change of the sample condition will create a new characteristic wave $\Phi_2=\varepsilon_2(t)e^{t(q_2x+q)}$. In the time period when the decaying wave $\Phi_1$ and arising wave $\Phi_2$ co-exist a new pattern induced by their interference is observed.

Figure 4A shows an aligned wave $\Phi_1$ created at 160°C and Figure 4B shows a double line pattern obtained after further heating the sample for 10 min at 205°C without the application of a load. This example shows that the dominant surface wavelength of the film at 205°C is about twice of that at 160°C ($q_2 \sim q_1/2$) due to strong softening of the polymer near its glass transition point. Figure 4B illustrates the pattern formed in a film which has not yet reached its steady state. This may be expressed as $\Phi=\Phi_1+\Phi_2=\varepsilon_1(t)e^{iq_rx}+\varepsilon_2(t)e^{i(q_1x/2+\varphi)}$. The value of the phase shift $\varphi$ is required for pattern symmetry. Similarly, the wavelength obtained at 190 °C is about 1.7 times of that obtained at 160 °C. After heating the sample with wave $\Phi_1$ to 190 °C for 10 min a single/double line modulated structure can be found, as shown in Figure 4C, which agrees well with $\Phi' = \Phi_1 + \Phi'_2 = \varepsilon_1(t)e^{iq_rx}+\varepsilon_2(t)e^{i(2q_1x/3)}$

In order to utilise such an interference effect to create complex patterns, it would be ideal if the wavelengths of both $\Phi_1$ and $\Phi_2$ could be chosen as desired. There is no limit to the number of the waves which may be included, and the obtained wave ($\Phi_1+ \Phi_2$) may further interfere with another wave $\Phi_3$ to create more complex patterning, e.g. $\Phi= [(\Phi_1+ \Phi_2) + \Phi_3] +\cdots$. Desired structures displaying abundant line arrangements with the appearance of bar-codes are possible. Such observed interference patterns and their evolution process are of use in the fundamental study of dynamic processes of polymer diffusion and creep, and wave mode selection due to film instability.

Example 4: Fabrication of a nanostructure.

The wavelength of the lined patterns obtained in the above-described germanium-capped PMGI template was in the micron to submicron range, and their amplitude was around. 20nm.

A 40 nm thick PMMA (Micro Chem Corp. 950 PMMA A2) resist layer was spin-coated on to the template surface and the resulting structure was baked at 160°C for 5 min before being cooled to room temperature. A glass wafer was employed to protect the surface flatness of the PMMA layer. After partially removing the PMMA layer by oxygen ($O_2$) plasma etching, the remaining PMMA in the trenches of the template was used as mask during etching of the thin germanium layer by sulphur hexafluoride ($SF_6$). Subsequently the patterned germanium layer was used as another mask during etching through the PMGI by $O_2$. plasma. Finally, a layer of functional material, such as metal, was deposited on to the structure and the desired nanostructures were obtained by lifting off the rest of the PMGI polymer.

By varying the parameters employed in the etching of the PMMA layer, the line width of the etched PMGI could be controlled. Figure 5A and 5B show, respectively, typical SEM images of random and ordered polymer structures on a silicon substrate after the final reactive ion etching (RIE). The channel width obtained was approximately 150 nm and the whole pattern was uniform and defect-free over a large area.

Figure 5C shows a magnetic wire array of 30nm thick Permalloy ($Ni_{80}Fe_{20}$) obtained in this way. In recent years, such fine patterned magnetic wires have attracted great scientific interest in particular in device applications. The magnetization reversal of fabricated permalloy wires were studied by the magneto-optic Kerr effect technique and the results are shown in Figure 5D. Compared to the unpatterned film (loop 1), the large increase in the coercivity obtained with the field along the wire (loop 2) is attributed to the shape anisotropy induced complication of magnetization reversal, such as the so-called "bucking effect" etc. When the field was applied perpendicular to the wires, a remarkable increase in the saturation field was observed (loop 3). This could be explained by the "magnetic charges" induced along the wire edges, resulting a magnetically hard behaviour in the direction perpendicular to the wires.

**Claims**

1. A template formed as a layered structure comprising a substrate, a single-phase polymer, and a semiconductor layer or metal layer on the polymer layer positioned on the substrate, wherein the polymer layer comprises a textured surface, the texturing being caused by induction of stress in the polymer layer with the semiconductor layer or metal layer present.

2. A template according to claim 1, wherein the single-phase polymer is selected from polymethylglutarimide (PMGI) or polymethylmethacrylate (PMMA).

3. A template according to claim 1 or claim 2, wherein the semiconductor is germanium.

4. A template according to any preceding claim, wherein the substrate comprises silicon.

5. A template according to any preceding claim, wherein the textured surface comprises parallel grooves.

6. A template according to any preceding claim, wherein the thickness of the single-phase polymer layer is 50-300 nm.

7. A template according to any of claims 1 to 5, wherein the thickness of the semiconductor layer is approximately 10 nm.

8. A method of manufacture of a structure on the nanometre scale **characterised by** comprising the steps of:

   providing a template as defined in any of claims 1 to 7;
   molding a material on to the template; and
   removing the molded material from the template to provide a structure on the nanometre scale.

9. A method according to claim 8, wherein the structure is an array, a grid, an optical device or an electronic device.

10. A method according to claim 9, wherein the optical device is a polariser.

11. A method according to claim 90, wherein the array is a magnetic wire array.

12. A method according to claim 11, wherein the magnetic wire array comprises Permalloy.

13. A method of making a template **characterised by** comprising the steps of:

    depositing a layer of a single-phase polymer on to a substrate;
    depositing a semiconductor layer or metal layer the polymer layer;
    baking the resulting structure from the deposition step at a temperature below the glass transition temperature ($T_g$) of the single-phase polymer;
    texturing, during the baking step, a surface of the polymer layer by inducing stress in the polymer layer; and
    annealing the resulting structure from the stress-induction step to provide a template.

14. A method according to claim 13, wherein the temperature employed in the baking step is in the range 120-200 ˚C.

15. A method according to any of claims 13 to 14, wherein the stress induced in the polymer is in the range 0.5-1 Mpa.

16. A method according to any of claims 13 to 15, wherein stress is induced in the polymer layer using a load bearing member comprising at least one contact surface engaging the surface to be textured.

17. A method according to claim 16, wherein the load bearing member comprises polydimethylsiloxane (PDMS).

**18.** A method according to claim 16 or claim 17, wherein the contact surface of the load bearing member is textured.

**19.** A method according to any of claims 13 to 18, wherein the single-phase polymer is selected from PMGI and PMMA.

**20.** A method according to any of claims 13 to 19 wherein the semiconductor is germanium.

**21.** A method according to any of claims 13 to 20, wherein the substrate comprises silicon.

**22.** A method according to any of claims 13 to 21, wherein stress-induction in the polymer layer results in the formation of parallel grooves in the surface of the polymer layer.

**23.** A method according to any of claims 13 to 22, wherein the thickness of the polymer layer is 50-300 nm.

**24.** A method according to any of claims 13 to 23, wherein the thickness of the semiconductor layer is approximately 10 nm.


**Patentansprüche**

**1.** Schablone, ausgebildet als Schichtstruktur, umfassend ein Substrat, ein Einphasenpolymer und eine Halbleiterschicht oder eine Metallschicht, die auf der Polymerschicht, die auf dem Substrat angeordnet ist, angeordnet ist, wobei die Polymerschicht eine strukturierte Oberfläche umfasst, wobei die Struktur auf die Induktion von Spannung auf die Polymerschicht, wobei die Halbleiterschicht oder die Metallschicht anwesend ist.

**2.** Schablone nach Anspruch 1, wobei das Einphasenpolymer ausgewählt ist aus Poylmethylglutarimid (PMGI) oder Polymethylmethacrylat (PMMA).

**3.** Schablone nach Anspruch 1 oder 2, wobei der Halbleiter Germanium ist.

**4.** Schablone nach einem der vorstehenden Ansprüche, wobei das Substrat Silizium umfasst.

**5.** Schablone nach einem der vorstehenden Ansprüche, wobei die strukturierte Oberfläche parallele Nuten aufweist.

**6.** Schablone nach einem der vorstehenden Ansprüche, wobei die Stärke der Einphasenpolymerschicht 50-300 nm beträgt.

**7.** Schablone nach einem der Ansprüche 1 bis 5, wobei die Stärke der Halbleiterschicht ungefähr 10 nm beträgt.

**8.** Verfahren zum Herstellen einer Struktur im Nanometermaßstab, **dadurch gekennzeichnet, dass** es folgende Schritt umfasst:

Vorsehen einer Schablone, wie sie in den Ansprüchen 1 bis 7 definiert ist;
Formen eines Materials auf der Schablone; und
Entfernen des geformten Materials von der Schablone, um eine Struktur im Nanometermaßstab zur Verfügung zu stellen.

**9.** Verfahren nach Anspruch 8, wobei die Struktur eine Matrix, ein Gitter, eine optische Einrichtung oder eine elektronische Einrichtung ist.

**10.** Verfahren nach Anspruch 9, wobei die optische Einrichtung ein Polarisator ist.

**11.** Verfahren nach Anspruch 9, wobei die Matrix eine Magnetdrahtmatrix ist.

**12.** Verfahren nach Anspruch 11, wobei die Magnetdrahtmatrix eine Permalloy-Legierung umfasst.

**13.** Verfahren zum Herstellen einer Schablone, **dadurch gekennzeichnet, dass** es die folgenden Schritte umfasst:

Abscheiden einer Schicht eines Einphasenpolymers auf ein Substrat;

Abscheiden einer Halbleiterschicht oder einer Metallschicht auf die Polymerschicht;

Brennen der resultierenden Struktur aus dem Abscheidungsschritt bei einer Temperatur unterhalb der Glasübergangstemperatur ($T_g$) des Einphasenpolymers;

Strukturieren einer Oberfläche der Polymerschicht während des Brennschritts durch Induktion von Spannung auf die Polymerschicht; und

Härten der resultierenden Struktur aus dem Spannungsinduktionsschritt, um eine Schablone zur Verfügung zu stellen.

14. Verfahren nach Anspruch 13, wobei die im Brennschritt verwendete Temperatur im Bereich von 120-200˚C liegt.

15. Verfahren nach Anspruch 13 oder 14, wobei der auf das Polymer ausgeübte Druck im Bereich von 0,5-1 MPa liegt.

16. Verfahren nach einem der Ansprüche 13 bis 15, wobei Spannung auf die Polymerschicht durch Verwendung eines tragenden Elements, umfassend zumindest eine Kontaktfläche, die in die zu strukturierende Oberfläche eingreift, ausgeübt wird.

17. Verfahren nach Anspruch 16, wobei das tragende Element Polydimethylsiloxan (PDMS) umfasst.

18. Verfahren nach Anspruch 16 oder 17, wobei die Kontaktfläche des tragenden Elements strukturiert ist.

19. Verfahren nach einem der Ansprüche 13 bis 18, wobei das Einphasenpolymer aus PMGI und PMMA ausgewählt ist.

20. Verfahren nach einem der Ansprüche 13 bis 19, wobei der Halbleiter Germanium ist.

21. Verfahren nach einem der Ansprüche 13 bis 20, wobei das Substrat Silizium umfasst.

22. Verfahren nach einem der Ansprüche 13 bis 21, wobei Spannungsinduktion auf die Polymerschicht in der Bildung paralleler Nuten in der Oberfläche der Polymerschicht resultiert.

23. Verfahren nach einem der Ansprüche 13 bis 22, wobei die Stärke der Polymerschicht 50-300 nm beträgt.

24. Verfahren nach einem der Ansprüche 13 bis 23, wobei die Stärke der Halbleiterschicht ungefähr 10 nm beträgt.

**Revendications**

1. Gabarit formé par une structure en couches, comprenant un substrat, un polymère à phase unique, et une couche de semi-conducteur ou une couche métallique posée sur la couche de polymère, elle-même posée sur le substrat, où la couche de polymère comprend une surface texturée, la texturation étant provoquée par induction d'une contrainte dans la couche de polymère avec la couche de semi-conducteur ou la couche métallique présente.

2. Gabarit selon la revendication 1, dans lequel le polymère à phase unique est choisi parmi le polyméthylglutarimide (PMGI) ou le poly(méthacrylate de méthyle) (PMMA).

3. Gabarit selon la revendication 1 ou 2, dans lequel le semi-conducteur est le germanium.

4. Gabarit selon l'une quelconque des revendications précédentes, dans lequel le substrat comprend du silicium.

5. Gabarit selon l'une quelconque des revendications précédentes, dans lequel la surface texturée comprend des rainures parallèles.

6. Gabarit selon l'une quelconque des revendications précédentes, dans lequel l'épaisseur de la couche du polymère à phase unique est de 50-300 nm.

7. Gabarit selon l'une quelconque des revendications 1 à 5, dans lequel l'épaisseur de la couche de semi-conducteur est d'environ 10 nm.

8. Procédé de préparation d'une structure à échelle du nanomètre, **caractérisé en ce qu'**il comprend les étapes de :

Disposition d'un gabarit tel que défini dans l'une quelconque des revendications 1 à 7 ;
Moulage d'un matériau sur le gabarit, et
Élimination du matériau moulé depuis le gabarit pour donner une structure à échelle du nanomètre.

9. Procédé selon la revendication 8, dans lequel la structure est un réseau, une grille, un dispositif optique ou un dispositif électronique.

10. Procédé selon la revendication 9, dans lequel le dispositif optique est un polariseur.

11. Procédé selon la revendication 9, dans lequel le réseau est un réseau à fils magnétiques.

12. Procédé selon la revendication 11, dans lequel le réseau à fils magnétiques contient un Permalloy.

13. Procédé de préparation d'un gabarit, **caractérisé en ce qu'**il comprend les étapes de :

Dépôt d'une couche d'un polymère à phase unique sur un substrat ;
Dépôt d'une couche de semi-conducteur ou d'une couche métallique sur la couche de polymère ;
Cuisson de la structure résultant de l'étape de dépôt, à une température inférieure à la température de transition vitreuse (Tv) du polymère à phase unique ;
Texturation, pendant l'étape de cuisson, d'une surface de la couche de polymère par induction d'une contrainte dans la couche de polymère, et
Recuit de la structure résultant de l'étape d'induction de la contrainte, pour donner un gabarit.

14. Procédé selon la revendication 13, dans lequel la température utilisée dans l'étape de cuisson se situe dans l'intervalle allant de 120 à 200˚C.

15. Procédé selon l'une quelconque des revendications 13 à 14, dans lequel la contrainte induite dans le polymère se situe dans l'intervalle allant de 0,5 à 1 MPa.

16. Procédé selon l'une quelconque des revendications 13 à 15, dans lequel la contrainte est induite dans la couche de polymère à l'aide d'un élément portant une charge, comprenant au moins une surface de contact engageant la surface à texturer.

17. Procédé selon la revendication 16, dans lequel l'élément portant une charge comprend du polydiméthylsiloxane (PDMS).

18. Procédé selon la revendication 16 ou 17, dans lequel la surface de contact de l'élément portant une charge est texturée.

19. Procédé selon l'une quelconque des revendications 13 à 18, dans lequel le polymère à phase unique est choisi parmi le PMGI et le PMMA.

20. Procédé selon l'une quelconque des revendications 13 à 19, dans lequel le semi-conducteur est le germanium.

21. Procédé selon l'une quelconque des revendications 13 à 20, dans lequel le substrat comprend du silicium.

22. Procédé selon l'une quelconque des revendications 13 à 21, dans lequel l'induction de la contrainte dans la couche de polymère résulte en la formation de rainures parallèles dans la surface de la couche de polymère.

23. Procédé selon l'une quelconque des revendications 13 à 22, dans lequel l'épaisseur de la couche de polymère est de 50-300 nm.

24. Procédé selon l'une quelconque des revendications 13 à 23, dans lequel l'épaisseur de la couche de semi-conducteur est d'environ 10 nm.

# Fig.1.

Figure 2

Figure 3

Figure 4

Figure 5

**EP 1 565 787 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **DEWETTING KAPH et al.** Capillary Force Lithography: Large-Area Patterning, Self-Organization, and Anisotropic. *Advanced Functional Materials,* June 2002, vol. 12 (6-7

**15**